# EUROPÄISCHE PATENTANMELDUNG

(11) **EP 1 795 623 A1**
(43) Veröffentlichungstag der Anmeldung: **13.06.2007**
(21) Anmeldenummer: 06122181.8
(22) Anmeldetag: 12.10.2006
(51) Int. Cl.: C23C 14/00, C23C 14/06, C23C 14/24, C23C 16/00, C23C 30/00

(54) **Verfahren zum Beschichten eines Grundkörpers mit platinmodifiziertem Aluminid sowie Werkstück**

(30) Priorität: 14.11.2005 EP 05405631
(71) Anmelder: Sulzer Metco AG, 5610 Wohlen (CH)
(72) Erfinder: Beele, Dr., Wolfram, 40883, Ratingen (DE)
(74) Vertreter: Kluthe, Stefan

(57) **Zusammenfassung**

Es wird ein Verfahren zum Beschichten eines Grundkörpers vorgeschlagen, bei welchem auf dem Grundkörper eine Schicht aus einem platinmodifizierten Aluminid der Form PtMAI erzeugt wird, wobei M die Metalle Eisen (Fe) oder Nickel (Ni) oder Cobald (Co) oder Kombinationen dieser Metalle bezeichnet, wobei die Schicht mittels einer physikalischen Abscheidung aus der Gasphase (PVD) erzeugt wird, wobei zumindest die beiden Komponenten Aluminium (Al) und Metall M physikalisch aus der Dampfphase abgeschieden werden, wobei die Abscheidung bei einem Prozessdruck von mindestens 0.1 mbar, vorzugsweise von mindestens 0.4 mbar und speziell zwischen 0.4 mbar und 0.6 mbar, durchgeführt wird. Ferner wird ein Werkstück, insbesondere eine Turbinenschaufel, mit einem Grundkörper vorgeschlagen, auf dem eine Schicht aufgebracht ist, die mit einem solchen Verfahren erzeugt ist

## Beschreibung

Die Erfindung betrifft ein Verfahren zum Beschichten eines Grundkörpers gemäss dem Oberbegriff des unabhängigen Anspruchs 1 sowie ein Werkstück mit einem Grundkörper, auf dem eine Schicht gemäss dieses Verfahrens aufgebracht ist.

Beim Betrieb von Turbinen, die beispielsweise als Triebwerke für Flugzeuge oder als landgestützte industrielle Gasturbinen eingesetzt werden, wird es angestrebt, eine möglichst hohe Temperatur des durch die Verbrennung entstehenden Gases zu realisieren, weil die Effizienz der Turbine umso besser wird je höher die Temperatur des Gases ist. Häufig übersteigt die Gastemperatur dabei die Schmelztemperatur der metallischen Verbindungen, aus denen die Teile gefertigt werden, die mit dem heissen Gas in Berührung kommen, beispielsweise die Turbinenschaufeln und die Brennkammer.

Daher ist es vor allem im Hochtemperaturbereich der Turbine üblich, zum einen als Werkstoff metallische Verbindungen zu wählen, die auch bei sehr hohen Temperaturen noch sehr gute mechanische Eigenschaften besitzen und zum anderen, die Werkstücke, wie z.B. die Turbinenschaufeln, aktiv zu kühlen und/oder mit Schutzschichten zu versehen, beispielsweise mit einer thermischen Schutzschicht TBC (thermal barrier coating).

Als Material für die thermisch am meisten belasteten Werkstücke der Turbine werden in der Regel Superlegierungen, welche üblicherweise Nickel- oder Kobaltbasislegierungen sind, verwendet. Diese Superlegierungen weisen zwar eine ausserordentliche Festigkeit bei sehr hohen Temperaturen auf, ihre Eigenschaften bezüglich Oxidationsbeständigkeit und Heisskorrosionsbeständigkeit in der aggressiven Atomsphäre der Turbine sind jedoch häufig nicht ausreichend. Um dieses Problem zu lösen, ist es bekannt, die Superlegierungen mit einer Schicht zu versehen, die eine sehr gute Heisskorrosionsbeständigkeit aufweist.

Zur Erzeugung heisskorrosions- bzw. heissoxidationsbeständiger Schichten auf Werkstücken aus Superlegierungen ist es beispielsweise bekannt, platinmodifizierte Aluminide der Form PtMAI zu verwenden, wobei M die Metalle Eisen (Fe) oder Nickel (Ni) oder Kobald (Co) oder Kombinationen dieser Metalle bezeichnet. Bei diesen Aluminiden wird ein Teil des Metalls M durch Platin (Pt) ersetzt. Es handelt sich hierbei um Diffusionsschichten. Zur Erzeugung der Schicht wird zunächst durch einen galvanischen Prozess eine Platinschicht auf den Grundkörper aufgebracht. Anschliessend wird in einem weiteren Verfahrensschritt der Grundkörper alitiert (aluminisiert). Dies geschieht durch Packzementierung oder durch chemische Abscheidung aus der Dampfphase (CVD) bei hohen Temperaturen und vorzugsweise eine anschliessende Wärmebehandlung.

Eine derartige platinmodifizierte Aluminidschicht wird beispielsweise in der EP-A-1 111 091 offenbart. Hier ist der Grundkörper beispielsweise aus einer Nickelbasislegierung. Nach elektrochemischem Aufbringen der Platinschicht erfolgt das Alitieren mittels CVD. Dabei diffundiert einerseits das Aluminium durch die Platinschicht in den Randbereich des Grundkörpers, andererseits diffundiert Nickel aus dem Grundkörper durch die Platinschicht nach aussen. Dadurch kommt es zur Ausbildung einer platinmodifizierten Nickelaluminidschicht.

Auch aus der EP-A-1 209 247 (entspricht US 6,602,356) ist es bekannt, eine platinmodifizierte Aluminidschicht durch galvanisches Aufbringen von Platin und anschliessendes Alitieren mittels eines CVD-Prozesses zu erzeugen, wobei zusätzlich beim CVD-Prozess ein aktives Element, beispielsweise Hafnium (Hf) in die Schicht eingebracht wird.

Ausgehend von diesem Stand der Technik, ist es eine Aufgabe der Erfindung, ein anderes Verfahren zum Beschichten eines Grundkörpers vorzuschlagen, bei welchem auf dem Grundkörper eine Schicht aus einem platinmodifizierten Aluminid erzeugt wird. Ferner soll durch die Erfindung ein Werkstück mit einem Grundkörper und einer derart erzeugten Schicht bereitgestellt werden.

Die diese Aufgaben lösenden Gegenstände der Erfindung sind durch die Merkmale der unabhängigen Ansprüche der jeweiligen Kategorie gekennzeichnet.

Erfindungsgemäss wird also ein Verfahren zum Beschichten eines Grundkörpers vorgeschlagen, bei welchem auf dem Grundkörper eine Schicht aus einem platinmodifizierten Aluminid der Form PtMAI erzeugt wird, wobei M die Metalle Eisen (Fe) oder Nickel (Ni) oder Cobald (Co) oder Kombinationen dieser Metalle bezeichnet, wobei die Schicht mittels einer physikalischen Abscheidung aus der Gasphase (PVD) erzeugt wird, wobei zumindest die beiden Komponenten Aluminium (AI) und Metall M physikalisch aus der Dampfphase abgeschieden werden, wobei die Abscheidung bei einem Prozessdruck von mindestens 0.1 mbar, vorzugsweise von mindestens 0.4 mbar und speziell zwischen 0.4 mbar und 0.6 mbar, durchgeführt wird.

Im Unterschied zu den bisher bekannten Verfahren zum Erzeugen platinmodifizierte Aluminidschichten, bei denen z.B. mittels CVD-Verfahren eine Diffusionsschicht über chemische Prozesse erzeugt wird, wobei vorgängig das Platin in Form einer dünnen Schicht galvanisch abgelagert wird, werden bei dem erfindungsgemässen Verfahren zumindest die beiden Komponenten Komponenten Metall M und Aluminium (Al) physikalisch aus der Dampfphase abgeschieden, wobei diese Abscheidung bei einem Prozessdruck von mindestens 10⁻¹ mbar durchgeführt wird.

Dies hat den erhebliche Vorteil, dass neben dem Aluminium auch das Metall M, also beispielsweise Nickel, Cobald oder Eisen über ein PVD-Verfahren zur Verfügung gestellt wird und nicht durch Diffusionsprozesse vom Grundkörper geliefert werden muss. Somit lässt sich auch eine ungewünschte Gradierung der Metall- M bzw der Aluminiumkonzentration vermeiden, die chemische Zusammensetzung der Schicht lässt sich genau einstellen.

Durch den im Vergleich zu anderen PVD-Verfahren wie beispielsweise EB-PVD (Electron-Beam-PVD) relativ hohen Prozessdruck spielen die möglicherweise stark unterschiedlichen Dampfdrücke der einzelnen Komponenten keine wesentliche Rolle mehr für die Zusammensetzung der zu erzeugenden Schicht. Insbesondere ist das Hochgeschwindigkeits- (HS-) PVD Verfahren für das erfindungsgemässe Verfahren geeignet.

Vorzugsweise werden das Metall M und das Aluminium gleichzeitig mittels PVD zur Verfügung gestellt.

Bei einer ersten bevorzugten Verfahrensführung werden alle Komponenten Aluminium (Al), Platin (Pt) und das Metall M physikalisch aus der Dampfphase abgeschieden. Dies hat zur Folge, dass die generierte Schicht eine Auflageschicht ist, die beispielsweise zu 80-90% auf dem Grundkörper aufbebaut wird, während bei den Diffusionsschichten ein deutlich grösserer Teil der Schicht, beispielsweise 50% in der Wand des Grundkörpers generiert wird. Dies ist insbesondere vorteilhaft im Hinblick auf Reparaturmassnahmen, bei denen typischerweise vor der Reparatur des Grundkörpers die Schicht entfernt werden muss. Mit dem erfindungsgemässen Verfahren lässt sich somit der sogenannte "lost wall"-Effekt vermindern, dass bei einer Reparatur in erheblichem Masse Material von dem Grundkörper abgetragen werden muss. Ferner lässt sich durch das Bereitstellen aller drei Komponenten mittels PVD die chemische Zusammensetzung der Schicht sehr genau und kontrolliert einstellen. Konzentrationsänderungen als Funktion der Schichtdicke wie sie bei der Generierung von Diffusionsschichten üblich sind, lassen sich mittels des erfindungsgemässen Verfahrens vermeiden. Natürlich ist es auch möglich, durch eine entsprechende Prozessführung gezielt Konzentrationsänderungen der Komponenten über die Dicke der Schicht herbeizuführen

Da zudem bei dieser Verfahrensführung auch das Metall M, also beispielsweise Nickel (Ni) physikalisch aus der Dampfphase abgeschieden wird, muss das Metall nicht durch Auswärtsdiffusion aus dem Grundkörper in die Schicht wandern. Somit lässt sich auch die Zusammensetzung bzw. die Stöchiometrie der Schicht wesentlich einfacher und genauer kontrollieren.

Ein weiterer Vorteil dieser Verfahrensführung ist es, dass sich durch die physikalische Abscheidung der Komponenten Verunreinigungen der Schicht vermeiden lassen, wie sie bei den bekannten Verfahren durch die chemischen Prozesse verursacht werden. So kommt es beispielsweise bei der galvanischen Abscheidung von Platin durch die Rückstände der Salze zu unerwünschten Einlagerungen von Schwefel (S) und Phosphor (P). Dies ist bei dem erfindungsgemässen Verfahren nicht möglich, weil Platin direkt in metallischer Form aus der Dampfphase physikalisch abgeschieden wird.

Es sind aber auch Verfahrensführungen möglich, bei denen nicht alle Komponenten der Schicht mittels PVD aufgebracht werden.

So ist es beispielsweise möglich, dass das Platin galvanisch aufgebracht wird und die Komponenten Aluminium und Metall M physikalisch aus der Dampfphase abgeschieden werden. Dann wird also Platin in an sich bekannter Weise mit einem galvanischen Verfahren aufgebracht und anschliessend wird das Aluminium und das Metall M mittels eines PVD-Prozesses aufgebracht.

Je nach Anwendungsfall kann es vorteilhaft sein, wenn die Schicht zusätzlich mindestens ein aktives Element enthält, wobei jedes aktive Element aus der Gruppe ausgewählt wird, die aus Scandium (Sc), Yttrium (Y), Lanthan (La), Titan (Ti), Zirconium (Zr), Hafnium (Hf), Vanadium (V), Niob (Nb), Tantal(Ta), Silizium (Si) und den Lanthanaiden Cer (Ce) bis Lutetium (Lu) besteht. Es ist bekannt, dass sich durch die Zugabe aktiver Elemente die Eigenschaften der Schicht positiv beeinflussen lassen. Vorzugsweise wird mindestens ein aktives Element physikalisch aus der Gasphase abgeschieden. Mit diesem erfindungsgemässen Verfahren ist es deutlich einfacher, die chemische Zusammensetzung der Schicht zu kontrollieren und auf gewünschte Werte einzustellen. Dies kann beispielsweise durch eine entsprechende Zusammensetzung und Ausgestaltung der Kathode gewährleistet werden, aus der die Komponenten für die Schicht herausgelöst werden. Auch wird durch die Verwendung des PVD-Verfahrens ein wesentlich breiterer Bereich an Elementen bzw. Elementkombinationen und/oder Konzentrationen zugänglich. Bei den bekannten CVD-Verfahren ist es nämlich oft schwierig, die für den Prozess üblicherweise verwendeten Halogenide in ausreichenden Konzentrationen mit aktiven Elementen anzureichern.

Vorzugsweise werden dann ein bis drei aktive Elemente abgeschieden, die insgesamt 0.2 bis 10 Gewichtsprozent der Schicht ausmachen.

Im Hinblick auf eine Verbesserung der Korrosionseigenschaften ist es eine vorteilhafte Massnahme, wenn zusätzlich Chrom (Cr) physikalisch aus der Dampfphase abgeschieden wird, das insgesamt 3 bis 25 Gewichtsprozent der Schicht ausmacht.

Gemäss einer bevorzugten Verfahrensführung wird zunächst in einem ersten Verfahrensschritt eine Platinschicht abgeschieden, und anschliessend werden in mindestens einem weiteren Verfahrensschritt die anderen Komponenten der Schicht abgeschieden.

Gemäss einer anderen bevorzugten Verfahrensführung werden alle Bestandteile der Schicht in einem Verfahrensschritt im wesentlichen gleichzeitig abgeschieden. Dies ermöglicht einen sehr schnellen und auch gleichmässigen Schichtaufbau.

Besonders bevorzugt wird bei dem erfindungsgemässe Verfahren die Abscheidung mittels Hochgeschindigkeits-PVD (HS-PVD) durchgeführt. Mit diesem Gasflusssputter-Verfahren lassen sich nämlich sehr hohe Abscheidungsraten von beispielsweise bis zu 100 µm/h erzielen.

Je nach Anwendungsfall ist es eine vorteilhafte Massnahme, wenn anschliessend auf der Schicht eine thermische Schutzschicht (TBC) aufgebracht wird. Hierfür sind alle an sich bekannten TBC-Materialien wie beispielsweise Yttrium (teil-) stabilisiertes Zirkoniumoxid geeignet.

Ferner wird durch die Erfindung ein Werkstück mit einem Grundkörper vorgeschlagen, auf dem eine erfindungsgemässe Schicht aufgebracht ist.

Gemäss einer bevorzugten Anwendung ist das Werkstück als Turbinenschaufel ausgestaltet.

Weitere vorteilhafte Massnahmen und bevorzugte Ausgestaltungen der Erfindung ergeben sich aus den abhängigen Ansprüchen.

Im Folgenden wird die Erfindung anhand der Zeichnung näher erläutert. In der schematischen Zeichnung zeigen:
- Fig. 1:: eine schematische Darstellung einer Vorrichtung zur Durchführung des erfindungsgemässen Verfahrens, und
- Fig. 2:: eine schematische Schnittdarstellug eines Ausführungsbeispiels eines erfindungsgemässen Werkstücks.

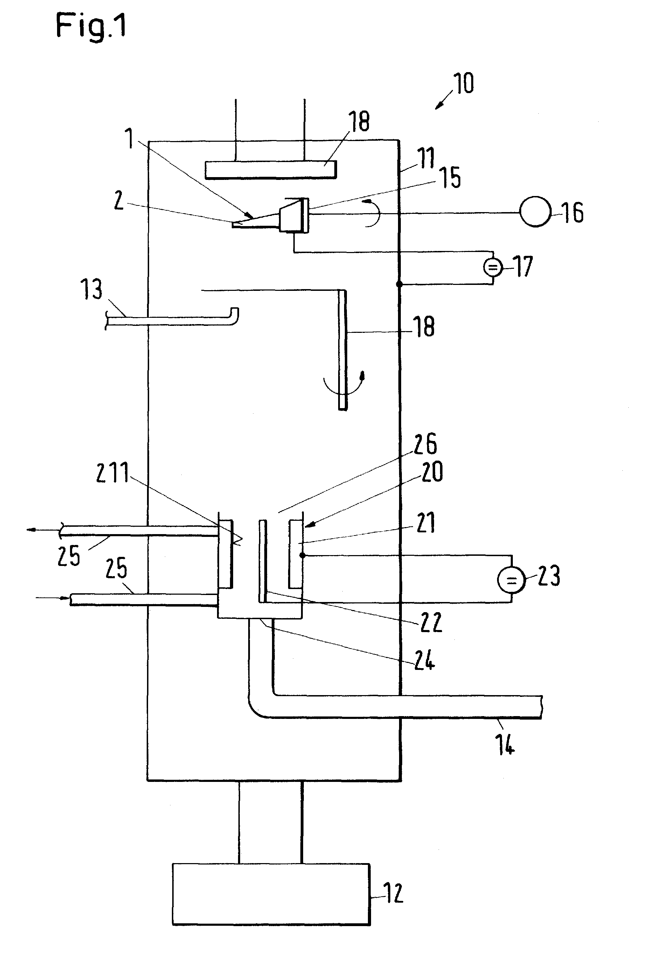

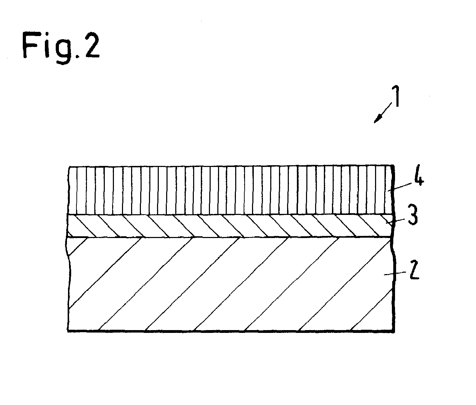

In der folgenden Beschreibung beziehen sich relative Lagebezeichnungen wie "oben", "unten", "oberhalb", "unterhalb" ... auf die in den Figuren 1 und 2 dargestellte Gebrauchslage. Es versteht sich, dass diese Lagebezeichnungen beispielhaft zu verstehen sind.

Bei dem erfindungsgemässen Verfahren zum Beschichten eines Grundkörpers 2 (Fig. 1) wird auf dem Grundkörper 2 eine Schicht 3 (Fig. 2) aus einem platinmodifiziereten Aluminid der Form PtMAI erzeugt, wobei M die Metalle Eisen (Fe) oder Nickel (Ni) oder Cobald (Co) oder Kombinationen dieser Metalle bezeichnet. Das erfindungsgemässe Verfahren ist dadurch gekennzeichnet, dass mindestens die beiden Komponenten Aluminium (Al), und Metall M der Schicht 3 mittels einer physikalischen Abscheidung aus der Dampfphase, also mittels eines PVD (physical vapor deposition) - Verfahrens erzeugt wird, wobei die Abscheidung bei einem Prozessdruck von mindestens 10-1 mbar (Millibar), vorzugsweise von mindestens 4·10⁻¹ mbar und speziell zwischen 4·10⁻¹ mbar und 6·10⁻¹ mbar durchgeführt wird. Prinzipiell sind alle an sich bekannten PVD-Verfahren für das erfindungsgemässe Verfahren einsetzbar, die bei solchen Prozessdrücken durchführbar sind. Diese sind dem Fachmann hinlänglich bekannt. Im Folgenden wird mit beispielhaftem Charakter auf das für die Praxis besonders bevorzugte Verfahren der Hochgeschwindigkeits-PVD, HS-PVD (HS: High speed) Bezug genommen.

Ferner wird auf die bevorzugte Verfahrensführung Bezug genommen, dass alle Komponenten der Schicht 3 physikalisch aus der Dampfphase abgeschieden werden. Es sind aber selbstverständlich auch andere Verfahrensführungen möglich So ist es beispielsweise möglich, dass das Platin galvanisch aufgebracht wird und die Komponenten Aluminium und Metall M physikalisch aus der Dampfphase abgeschieden werden. Dann wird also Platin in an sich bekannter Weise mit einem galvanischen Verfahren aufgebracht und anschliessend wird das Aluminium und das Metall M mittels eines PVD-Prozesses aufgebracht.

Desweiteren wird mit ebenfalls beispielhaftem Charakter angenommen, dass als Metall M Nickel Verwendung findet, das heisst die Schicht 3 ist eine platinmodifizierte Nickelalumind (PtNiAl) -Schicht. Natürlich gelten die Erläuterungen in sinngemäss gleicher Weise auch für Eisen, Cobalt beziehungsweise Kombinationen dieser drei Elemente als Metall M.

Fig. 1 zeigt in einer schematischen Darstellung einer Vorrichtung, die zur Durchführung eines erfindungsgemässen Verfahrens geeignet ist. Diese Vorrichtung ist gesamthaft mit dem Bezugszeichen 10 bezeichnet. Im speziellen ist die Vorrichtung 1 zur Durchführung von HS-PVD geeignet. HS-PVD ist ein Gasfluss-Sputterverfahren bzw. ein reaktives Gasfluss-Sputterverfahren. Das Gasfluss-Sputtern wird beispielsweise in der WO-A-98/13531 und in der DE-A-42 35 953 beschrieben. Bei diesem Verfahren wird ein Inertgas, beispielsweise Argon, durch eine Hohlkathode geleitet, in welcher eine Anode angeordnet ist. Die Argonatome werden ionisiert und treffen dann auf der Kathode auf, wodurch Kathodenmaterial abgestäubt wird, dass dann durch den Inertgasstrom aus der Kathode heraus zum Substrat geführt wird. Im Falle des reaktiven Gasfluss-Sputtern ist zwischen dem Austritt der Kathode und dem Substrat eine Zuführung für ein Reaktivgas, beispielsweise Sauerstoff, vorgesehen, durch welches das abgestäubte Kathodenmaterial oxidiert wird.

Im Folgenden wird nun die Vorrichtung 10 beschrieben, die in Fig. 1 schematisch dargestellt ist.

Die Vorrichtung 10 für den HS-PVD Prozess umfasst eine Kammer 11, in welcher mittels einer Pumpeinrichtung 12 ein Vakuum erzeugbar ist. Typischerweise ist der Druck in der Kammer 11 für die HS-PVD im Bereich von 0.1 mbar bis 1 mbar.

In der Kammer ist eine Kathodenanordnung 20 vorgesehen, die als Hohlkathodenanordnung ausgestaltet ist, an deren Innenseite Kathodenmaterial befestigt ist. Im dargestellten Ausführungsbeispiel ist die Kathodenanordnung 20 linear ausgestaltet, womit gemeint ist, dass das Kathodenmaterial in Form plattenförmiger Elemente 21 ausgestaltet ist. Es sind zwei plattenförmige Elemente 21 mit Kathodenmaterial vorgesehen, die im wesentlichen parallel zueinander mit einander zugewandten Frontflächen 211 im Innern der Kathodenanordnung 20 angeordnet sind. Natürlich können auch mehr als zwei plattenförmige Elemente 21 vorgesehen sein, die paarweise parallel zueinander angeordnet sind. Zwischen den beiden plattenförmigen Elementen 21 ist eine stabförmige Anode 22 vorgesehen, die über eine Gleichspannungsquelle 23 mit der Kathodenanordnung 20 verbunden ist. Die Gleichspannungsquelle 23 kann beispielsweise Spannungen von bis zu 1000 V liefern, womit Ströme von bis zu 150 A generierbar sind. Der Arbeitsbereich variiert, je nach Anordnung und Material kann die Vorrichtung mit einer Leistung von wenigen kW bis zu etwa 150 kW betrieben werden. Ferner ist eine Kathodenkühlung 25 vorgesehen, durch welche ein Kühlmittel, beispielsweise Wasser, zu der Kathodenanordnung 20 hin und von dieser weggeleitet werden kann, so wie dies die beiden Pfeile in Fig. 1 andeuten.

An der unteren Seite der Kathode ist ein Gaseinlass 24 vorgesehen, der über eine Gaszuführung 14 mit einem nicht dargestellten Gasreservoir verbunden ist. Durch diesen Gaseinlass 24 strömt im Betriebszustand ein Inertgas, vorzugsweise Argon, in die Kathodenanordnung 20. Je nach Ausgestaltung der Kathodenanordnung 20 kann der Gaseinlass 24 als Verteiler ausgestaltet sein, der das Inertgas in vorbestimmter Weise in der Kathodenanordnung 20 verteilt. Auch die Wandungen der Kathodenanordnung 20 können zum Führen des Inertgasstroms dienen. Am darstellungsgemäss oberen Ende der Kathodenanordnung ist ein Auslass 26 vorgesehen, der vorzugsweise als spaltförmige Öffnung ausgebildet ist. Durch den Auslass 26 strömt das Inertgas zusammen mit dem abgestäubten Kathodenmaterial aus der Kathodenanordnung 20 heraus.

Darstellungsgemäss oberhalb der Kathodenanordnung 20 ist der Grundkörper 2 eines Werkstücks 1 vorgesehen, der in einer Halteeinrichtung 15 angeordnet ist. Um eine möglichst gleichmässige Beschichtung des Grundkörpers 2 zu gewährleisten ist die Halteeinrichtung 15 mittels eines Motors, beispielsweise eines Servomotors, drehbar wie dies der Drehpfeil in Fig. 1 andeutet. Ferner ist die Halteeinrichtung 15 mit einer Spannungsquelle 17 verbunden. Das Anlegen einer Vorspannung mittels der Spannungsquelle 17 kann dazu genutzt werden, den ionisierten Teil des Kathodenmaterials zur Schichtkompaktierung auf den Grundkörper 2 hin zu beschleunigen.

Im Bereich des Werkstücks 1 ist ferner eine Heizeinrichtung 18 vorgesehen, mit welcher der Grundkörper 2 über Wärmestrahlung oder Konvektion beheizbar ist. Vorzugsweise sind Heizelemente (nicht dargestellt) der Heizeinrichtung auf beiden Seiten des Grundkörpers 2 vorgesehen um diesen möglichst gleichmässig auf eine homogene Temperatur zu erhitzen. Mit der Heizeinrichtung 18 kann das Werkstück auf beispielsweise 900°C oder mehr aufgeheizt werden.

Zwischen dem Auslass 26 der Kathodenanordnung 20 und dem Werkstück 1 kann noch ein schwenkbarer Schirm 19 vorgesehen sein, der im eingeschwenkten Zustand das Werkstück 2 gegen den Auslass 26 abschirmt.

Darstellungsgemäss unterhalb des schwenkbaren Schirms 19 ist der Austritt einer Reaktivgaszuführung 13 vorgesehen, durch die ein Reaktivgas in die Kammer 11 und insbesondere in den Inertgasstrom, welcher das abgestäubte Kathodenmaterial mit sich führt, einbringbar ist. Hierdurch wird es möglich, abgestäubtes Kathodenmaterial, das beispielsweise in metallischer Form vorliegt, chemisch zu modifizieren. Soll z.B eine thermische Schutzschicht (TBC: thermal barrier coating) auf dem Grundkörper abgeschieden werden, so kann Zirkonium und Yttrium in metallischer Form von dem Kathodenmaterial abgestäubt werden und durch die Reaktivgaszuführung Sauerstoff als Reaktivgas in den Materialstrom eingebracht werden, sodass das Zirkonium und das Yttrium oxidiert werden. Auf dem Grundkörper 2 scheidet sich dann eine thermische Schutzschicht von yttriumstabilisierten Zirkoniumoxid ab. Je nach Anwendung können natürlich auch andere Reaktivgase wie beispielsweise Stickstoff zugeführt werden.

Es versteht sich, dass die hier beschriebene Anordnung der einzelnen Bauteile in der Kammer 11 nur beispielhaft zu verstehen ist. Natürlich kann anstelle der in Fig. 1 dargestellten vertikalen Anordnung auch eine horizontale Anordnung vorgesehen werden.

Zur Durchführung des erfindungsgemässen Verfahrens, wird auf dem Grundkörper 2 in diesem Ausführungsbeispiel eine Schicht 3 aus einem platinmodifizierten Nickelaluminid mittels HS-PVD abgeschieden, wobei sowohl Pt als auch Al als auch Ni physikalisch aus der Dampfphase abgeschieden werden. Optional ist es auch noch möglich, zusätzlich ein oder mehrere aktive Elemente in die Schicht einzubauen, um deren Eigenschaften gezielt zu modifizieren. Die aktiven Elemente werden vorzugsweise aus der folgenden Gruppe von Elementen ausgewählt: Scandium (Sc), Yttrium (Y), Lanthan (La), Titan (Ti), Zirconium (Zr), Hafnium (Hf), Vanadium (V), Niob (Nb), Tantal(Ta), Silizium (Si) sowie die Lanthanaide Cer (Ce) bis Lutetium (Lu), dies sind die Elemente der Ordnungszahlen 58 bis 71. Aus praktischen Gründen werden vorzugsweise höchstens drei aktive Elemente abgeschieden, die insgesamt 0.2 bis 10 Gewichtsprozent der Schicht 3 ausmachen.

Der Pt- und der Al-Gehalt der Schicht 3 beträgt vorzugsweise jeweils 10-35 Gewichtsprozent und besonders bevorzugt jeweils 15-20 Gewichtsprozent.

Im Hinblick auf eine Verbesserung der Korrosionseigenschaften kann es vorteilhaft sein , zusätzlich noch Chrom (Cr) mit einer Konzentration von 3 bis 25 Gewichtsprozent in die Schicht 3 einzubringen.

Die gewünschte chemische Zusammensetzung der Schicht 3 kann durch die Ausgestaltung der plattenförmigen Elemente 21 mit dem Kathodenmaterial sehr genau und reproduzierbar eingestellt werden. Dazu ist es beispielsweise möglich, zunächst die Elemente, welche die Schicht 3 enthalten soll, in der vorgebbaren Stöchiometrie bzw. mit den vorgebbaren Konzentrationsanteilen zu mischen oder zu legieren und anschliessend aus dieser Mischung die plattenförmigen Elemente 21 herzustellen. Ferner ist es möglich, die plattenförmigen Elemente 21 segmentiert herzustellen, sodass die plattenförmigen Elemente 21 unterschiedliche Zonen aufweisen, in denen unterschiedliche Materialien vorgesehen sind. Über die Grösse und die Position dieser Zonen in der Kathodenanordnung 20 können die richtigen Konzentrationsverhältnisse eingestellt werden. Natürlich ist auch eine Kombination dieser beiden Varianten möglich. Ferner ist es möglich, Komponenten der aufzutragenden Schicht durch Zuführung eines Reaktivgases durch die Reaktivgaszuführung 13 gezielt zu modifizieren.

Durch diese Möglichkeit, über die Ausgestaltung des Kathodenmaterials die chemische Zusammensetzung der Schicht 3 reproduzierbar und genau einzustellen, ist das PVD-Verfahren bezüglich der verarbeitbaren Materialen und der realisierbaren Konzentrationsbereiche der einzelnen Komponenten deutlich flexibler als die CVD-Verfahren.

Zum Aufbringen der Schicht 3 werden die der gewünschten Zusammensetzung der Schicht 3 entsprechend ausgestalteten plattenförmigen Elemente 21 mit dem Kathodenmaterial in der Kathodenanordnung 20 montiert. Um den Abscheidungsprozess zu optimieren, wird der Grundkörper 2 mittels der Heizeinrichtung 18 auf eine vorbestimmte Temperatur, beispielsweise 900°C aufgeheizt.

In die Kathodenanordnung 20 wird durch den Gaseinlass 24 Inertgas, vorzugsweise Argon, eingeführt. Aufgrund der Spannungsdifferenz zwischen der Anode 22 und der Kathodenanordnung 20 wird das Argon ionisiert. Die ionisierten Argonteilchen werden auf das auf den plattenförmigen Elementen 21 befindliche Kathodenmaterial hin beschleunigt und schlagen dort bei ihrem Auftreffen Atome, also beispielsweise metallisches Pt, Al und Ni, oder Atomcluster aus der Oberfläche 211 der Elemente 21 heraus. Das herausgelöste bzw. abgestäubte Kathodenmaterial wird dann in dem Inertgasstrom durch den Auslass 26 in Richtung des Grundkörpers 2 transportiert, wo es sich in Form der Schicht 3 abscheidet. Dabei wird der Grundkörper 2 mittels der Halteeinrichtung 15 und des Motors 16 rotiert, sodass eine möglichst gleichmässige Schicht 3 entsteht.

Der besondere Vorteil des HS-PVD-Verfahrens ist darin zu sehen, dass sich mit diesem Verfahren sehr hohe Abscheidungsraten von beispielsweise 100 µm/h erzielen lassen.

Da beim PVD-Verfahren das Platin (und natürlich auch die anderen metallischen Elemente) direkt in metallischer Form aus der Gasphase abgeschieden werden, werden solche Verunreinigungen wie sie beim galvanischen Abscheiden beispielsweise durch die verwendeten Salze resultieren, vermieden. Nachteilige Einlagerungen von Schwefel pder Phosphor können so vermieden werden.

Bezüglich der Verfahrensführung sind mehrere Varianten möglich. So ist es beispielsweise möglich zunächst in einem ersten Verfahrensschritt eine Platinschicht abzuscheiden und anschliessend in einem oder mehreren weiteren Verfahrensschritten die anderen Komponenten der Schicht 3 abzuscheiden. Dazu wird zwischen den einzelnen Verfahrensschritten das Kathodenmaterial manuell oder automatisch gewechselt. Beim manuellen Wechseln werden beispielsweise die plattenförmigen Elemente 21 oder Teile davon ausgewechselt. Natürlich können auch mehrere Kathodenanordnungen vorgesehen sein, die beispielsweise wahlweise aktiviert werden. Eine weitere Variante besteht darin, den Gaseinlass 24 bzw. den Gasverteiler zu verschieben, sodass er mehr oder weniger tief in die Kathodenanordnung eintaucht. Diese Massnahme ist insbesondere beim partiellen Zulegieren vorteilhaft.

Mit dieser Verfahrensführung lässt sich der zweistufige Prozess imitieren, der in den an sich bekannten CVD-Verfahren mit vorgängiger galvanische Abscheidung der Pt-Schicht durchgeführt wird.

Andererseits ist es auch möglich, alle Bestandteile der Schicht 3 in einem Verfahrensschritt im wesentlichen gleichzeitig abzuscheiden. Dazu können auch mehrere, beispielsweise hintereinander angeordnete Kathodenanordnungen 20 vorgesehen sein.

Insbesondere in solchen Fällen, in denen die Schicht 3 in mehr als einem Verfahrensschritt abgeschieden wird, kann es vorteilhaft sein, den beschichteten Grundkörper 2 anschliessend einer an sich bekannten Wärmebehandlung zu unterziehen, um die Schicht 3 durch Diffusionsprozesse möglichst homogen zu machen.

Natürlich ist es auch möglich, die Schicht 3 bewusst mehr als einphasig auszugestalten.

Das PVD-Verfahren wird bei einem Prozessdruck in der Kammer von mindestens 0.1 mbar durchgeführt. Dazu wird die Kammer 11 zunächst auf ein Startvakuum von mindestens 5·10⁻³ mbar abgepumpt und anschliessend der PVD-Prozess bei mindestens 0.1 mbar durchgeführt. Vorzugsweise beträgt der Prozessdruck mindestens 4·10⁻¹ mbar und speziell zwischen 4·10⁻¹ mbar und 6·10⁻¹ mbar. Für diesen Prozessdruck wird die Kammer zunächst auf ein Startvakuum von 10⁻³ mbar evakuiert. Mit solchen Prozessdrücken liegt man deutlich über denjenigen, die beispielsweise für ein typisches EB-PVD-Verfahren Verwendung finden. Bei EB-PVD beträgt der Prozessdruck üblicherweise 10⁻³ mbar bis 2·10⁻² mbar, wobei vorher auf einen Startdruck von 10⁻⁵ mbar bis 10⁻⁶ mbar evakuiert wird

Eine weitere Variante des erfindungsgemässen Verfahrens besteht darin, nach dem Erzeugen der Schicht 3 auf dieser noch eine thermische Schutzschicht (TBC) aufzubringen. Die TBC-Schicht kann mittels aller an sich bekannter Verfahren aufgebracht werden, also beispielsweise mittels eines PVD-Verfahrens oder mittels eines thermischen Spritzprozesses. Die TBC-Schicht 4 kann aus allen dafür bekannten Materialien bestehen, also beispielsweise aus ganz oder teilweise yttriumstabilisierten Zirkoniumoxid (YSZ), einer Kombination aus YSZ mit einem dritten Oxid oder den neueren TBC-Materialien wie Spinelle, Perovskite und Pyrochlore.

Das erfindungsgemässe Verfahren eignet sich insbesondere zum Erzeugen von heisskorrosions- und heissoxidationsbeständigen Schutzschichten auf Turbinenschaufeln oder anderen Gasturbinenkomponenten, die stark hitzeexponiert sind.

## Patentansprüche

1. Verfahren zum Beschichten eines Grundkörpers, bei welchem auf dem Grundkörper eine Schicht aus einem platinmodifizierten Aluminid der Form PtMAI erzeugt wird, wobei M die Metalle Eisen (Fe) oder Nickel (Ni) oder Cobald (Co) oder Kombinationen dieser Metalle bezeichnet, **dadurch gekennzeichnet, dass** die Schicht mittels einer physikalischen Abscheidung aus der Gasphase (PVD) erzeugt wird, wobei zumindest die beiden Komponenten Aluminium (AI) und Metall M physikalisch aus der Dampfphase abgeschieden werden, wobei die Abscheidung bei einem Prozessdruck von mindestens 0.1 mbar, vorzugsweise von mindestens 0.4 mbar und speziell zwischen 0.4 mbar und 0.6 mbar, durchgeführt wird.

2. Verfahren nach Anspruch 1, bei welchem alle Komponenten Aluminium (Al), Platin (Pt) und das Metall M physikalisch aus der Dampfphase abgeschieden werden.

3. Verfahren nach Anspruch 1, bei welchem das Platin galvanisch aufgebracht wird und die Komponenten Aluminium und Metall M physikalisch aus der Dampfphase abgeschieden werden.

4. Verfahren nach einem der Ansprüche 1-3, bei welchem die Schicht zusätzlich mindestens ein aktives Element enthält, wobei jedes aktive Element aus der Gruppe ausgewählt wird, die aus Scandium (Sc), Yttrium (Y), Lanthan (La), Titan (Ti), Zirconium (Zr), Hafnium (Hf), Vanadium (V), Niob (Nb), Tantal(Ta), Silizium (Si) und den Lanthanaiden Cer (Ce) bis Lutetium (Lu) besteht.

5. Verfahren nach Anspruch 4, bei welchem mindestens ein aktives Element physikalisch aus der Gasphase abgeschieden wird.

6. Verfahren nach einem der Ansprüche 4-5, wobei ein bis drei aktive Elemente abgeschieden werden, die insgesamt 0.2 bis 10 Gewichtsprozent der Schicht ausmachen.

7. Verfahren nach einem der vorangehenden Ansprüche, bei welchem zusätzlich Chrom (Cr) physikalisch aus der Dampfphase abgeschieden wird, das insgesamt 3 bis 25 Gewichtsprozent der Schicht ausmacht.

8. Verfahren nach einem der vorangehenden Ansprüche, wobei zunächst in einem ersten Verfahrensschritt eine Platinschicht abgeschieden wird und anschliessend in mindestens einem weiteren Verfahrensschritt die anderen Komponenten der Schicht abgeschieden werden.

9. Verfahren nach einem der vorangehenden Ansprüche, bei welchem alle Bestandteile der Schicht in einem Verfahrensschritt im wesentlichen gleichzeitig abgeschieden werden.

10. Verfahren nach einem der vorangehenden Ansprüche, bei welchem die physikalische Abscheidung mittels Hochgeschindigkeits-PVD (HS-PVD) durchgeführt wird.

11. Verfahren nach einem der vorangehenden Ansprüche, bei welchem anschliessend auf der Schicht eine thermische Schutzschicht (TBC) aufgebracht wird.

12. Werkstück mit einem Grundkörper, auf dem eine Schicht aufgebracht ist, die mit einem Verfahren gemäss einem der vorangehenden Ansprüche erzeugt ist.

13. Werkstück nach Anspruch 12, ausgestaltet als Turbinenschaufel.
